# EUROPEAN PATENT SPECIFICATION

(11) **EP 4 440 254 B1**
(45) Date of publication and mention of the grant of the patent: **23.09.2026**
(21) Application number: 23165666.1
(22) Date of filing: 30.03.2023
(51) Int. Cl.: H05K 5/00, H05K 5/02

(54) **SHIELD FOR FAN-COOLED UNITS**
ABSCHIRMUNG FÜR LÜFTERGEKÜHLTE EINHEITEN
BLINDAGE POUR UNITÉS REFROIDIES PAR VENTILATEUR

(43) Date of publication of application: 02.10.2024
(73) Proprietor: Aptiv Technologies AG, 8200 Schaffhausen (CH)
(72) Inventor: BARUS, Lukasz, Dublin, 2 (IE); CISAK, Bartlomiej, Dublin, 2 (IE); KORTA, Jakub, Dublin, 2 (IE)
(74) Representative: Lewis Silkin LLP

(56) References cited:
- CN-U- 202 285 471
- CN-U- 213 007 982
- JP-A- 2002 118 925
- JP-A- 2018 188 974
- JP-A- H06 327 121
- US-A1- 2004 057 209

## Description

### Introduction

The present disclosure relates to a shield for fan-cooled units, e.g. an environmental shield that prevents water from entering an electronic control unit (ECU) during use and testing.

### Background

Electronic components and computer processors are known to generate heat during use, which can result in reduced performance and failure if not addressed. Common solutions for reducing the heat load of a component include heat sinks, heat spreaders and fan-cooling.

A fan-cooling unit is a device for transferring heat which locates a high rpm fan close to a processor or like component and either blows cool air onto or draws hot air away from it during use. Cooling is enabled by air movement where hot air in the proximity of the component surface is replaced by cooler air.

Fan units are practical solutions, but they typically require some form of vent to enable an air flow path between inside and outside the housing within which the component is located. Such a vent may be in the form of a grill or multi-apertured structure which prevents relatively large solid objects from passing through it, while permitting air or other fluid through to circulate for the purposes of cooling. The fan itself is normally located on the internal side of the vent within the housing so it is protected from external objects and damage. The fan direction is generally configured to expel hot air from the housing, so as to avoid dust/moisture being drawn into the vent.

It will be appreciated that while external solid objects should be prevented from access to the inside of the housing and its components, so too should some fluids such as water from condensation, rain, leakage, etc. While the rotating fan itself may provide some amount of water repulsion outwardly from the unit, it is generally impractical to provide a vent that is impervious to water, while also enabling air flow sufficient for heat exchange purposes. The contents of the unit are particularly vulnerable when powered down and the fan is off.

It is known to test electronic devices for compliance with standards, such as IPx where the device can be certified resistant to water at the splash level, i.e. it can survive minor water splashes, droplets or even showers although it is not designed to be submerged. Prior examples of cover devices for a vent include: JP2002118925A, CN213007982U and JPH06327121A, US2004/057209, CN202285471U and JP2018188974A.

The present disclosure seeks to address issues with conventional solutions or at least provide an alternative to the public and manufacturers of electronic devices.

### Summary

According to a first aspect, a shield for a vent in a housing for electronic components is provided according to claim 1. The shield is of simple pressed sheet metal construction, e.g. comprising: an interfacing side for interfacing with the vent and/or fan-cooled unit in the housing; an opening configured for communicating with the interfacing side which, in use, diverts airflow to or from the vent or fan-cooled unit in use. An external wall, opposite the interfacing side, substantially shields the vent and/or fan-cooled unit in the housing, such that ingress of fluid from directions not toward with the opening is mitigated. The shield herein may alternatively termed or function as a protective cover, hood, shroud, enclosure, manifold, cowling, etc. relative to a vent opening for the purpose of minimising liquid ingress thereinto during use and testing. At the same time, air from the fan unit is relatively unimpeded to perform its cooling function, by having an outlet or inlet path through the opening.

Alternatively, the invention can be expressed as a shield for a vent or cooling-fan unit in a housing for electronic components, comprising: an outwardly projectable wall for substantially covering the vent or cooling-fan unit and, at edges of the wall, interfacing with the housing; and an opening for communicating with the vent or cooling-fan unit to, in use, divert airflow to or from the vent or fan-cooled unit while ingress of fluid from a direction not into the opening is mitigated by the outwardly projectable wall. In practice, the edges of the wall interface/contact with the housing about the vent on at least three sides, e.g. upper, left and right sides, creating a seal therewith. The lower side comprises the opening, although it too may have a contact edge with the housing.

The wall is contoured, i.e. contoured to project outwardly relative to the housing/vent. The contour is narrow opposite to the opening and widen toward the opening. Broadly, the surface of the wall is tapered to gradually widen toward the outlet opening. A generally wide cross section should be maintained so as not to inhibit cooling airflow.

As a consequence of the invention, the problem of water droplets forming/falling in the proximity of a fan-unit or vent opening in a housing associated with electronic components, such as an ECU, is mitigated. Specifically, the shield acts to deflect droplets directed (e.g. by falling under gravity or in a spray/shower) from above or at an angle toward/into the fan unit/vent from entering said vent. At the same time, airflow is maintained through the opening which is positioned to face a direction least vulnerable to liquid ingress (i.e. opposite to the most common/expected direction of droplets falling under gravity or in a spray/shower). By way of example, in general terms the shield should be configured to prevent water droplet/shower ingress travelling in a downward direction or at least if the housing is tilted by up to fifteen degrees in any direction from horizontal, assuming the vent is located on a vertical side edge of the housing. The invention provides a shielding element for countering any angle of attack of a water droplet/shower/jet toward the vent, unless it is directly pointed at the opening. It is less effective if water comes "up and under" the shield through the open outlet, however, it will be appreciated that it is generally possible to predict from which angle unwanted moisture is likely to approach the housing.

The shield comprises interfacing features for coupling to a vent opening/fan unit by permanent or removable means. For example, an edge of the wall/interfacing side may be configured to slide into a channel provided in the ECU housing, proximate a vent. Multiple fixture possibilities and surface features such as holes (for screws), profiles/ridges (for interference fit into a channel) or clip mechanisms may be employed to secure the shield in place. Preferably, abutting edges of the interfacing side of the wall will be sealed with the housing or its interfacing features to prevent ingress of liquid at that edge.

According to the invention, the shield is pressed from sheet metal. In other examples, the shield may be moulded from plastics, e.g. by thermoforming, vacuum forming, injection moulding, etc. In examples outside the present scope, the shield may be overmouled with the housing.

In a second broad aspect, the invention envisages a combination of the shield as described above with an ECU housing which is configured to receive the shield at an interface thereof. In one form, a maximum dimension of the shield's external surface should not exceed a footprint of the ECU housing. In this way, installation of the ECU is not inhibited by the shield excessively protruding from one side thereof. For example, the ECU may have protruding brackets/mounting structures, and the shield should not extend substantially beyond such structures.

In embodiments, the shield may be provided as a set of shields of differing dimensions that may be selected according to the housing to which it is to be attached, e.g. according to available space for installation.

A third aspect of the invention is embodied by a method according to claim 6.

### Brief Description of Drawings

Illustrative embodiments will now be described with reference to the accompanying drawings in which:
Figure 1 illustrates an overview of a shield according to the invention in place over a cooling vent of a housing for an electronic control unit;
Figure 2 illustrates a front elevation view of the housing from Figure 1;
Figure 3 illustrates a side elevation, partial cross section, view of the shield in place at a cooling vent of the housing;
Figure 4 illustrates a front elevation, partial cross section, view of the shield in place at a cooling vent of the housing;
Figure 5 illustrates a frontal overview from a low angle of the shield;
Figure 6 illustrates a frontal overview from a high angle of the shield; and
Figure 7 illustrates a rear overview from a low angle of the shield.

### Detailed Description

The following description presents exemplary embodiments and, together with the drawings, serves to explain principles of the invention. However, the scope of the invention is not intended to be limited to the precise details of the embodiments or exact adherence with all system features and/or method steps, since variations will be apparent to a skilled person and are deemed also to be covered by the description. Terms for components used herein should be given a broad interpretation that also encompasses equivalent functions and features.

In some cases, several alternative terms (synonyms) for structural, system features have been provided but such terms are not intended to be exhaustive. For the avoidance of doubt, any terms separated by the "/" symbol generally refer to alternative "or" expressions where the terms can be used interchangeably. Descriptive terms should also be given the broadest possible interpretation; e.g. the term "comprising" as used in this specification means "consisting at least in part of" such that interpreting each statement in this specification that includes the term "comprising", features other than that or those prefaced by the term may also be present. Related terms such as "comprise" and "comprises" are to be interpreted in the same manner. Any directional terms such as "vertical", "horizontal", "up", "down", "sideways", "upper" and "lower" are used for convenience of explanation usually with reference to the form shown in illustrations and are not intended to be ultimately limiting if an equivalent function can be achieved with an alternative dimension and/or direction. All directional terms are relative to each other.

The description herein refers to embodiments with particular combinations of steps or features, however, it is envisaged that further combinations and cross-combinations of compatible steps or features between embodiments will be possible. Indeed, isolated features may function independently as an invention from other features and not necessarily require implementation as a complete combination.

It will be understood that the illustrated embodiments show applications only for the purposes of explanation. In practice, the invention may be applied to many different configurations, where the embodiment is straightforward for those skilled in the art to implement.

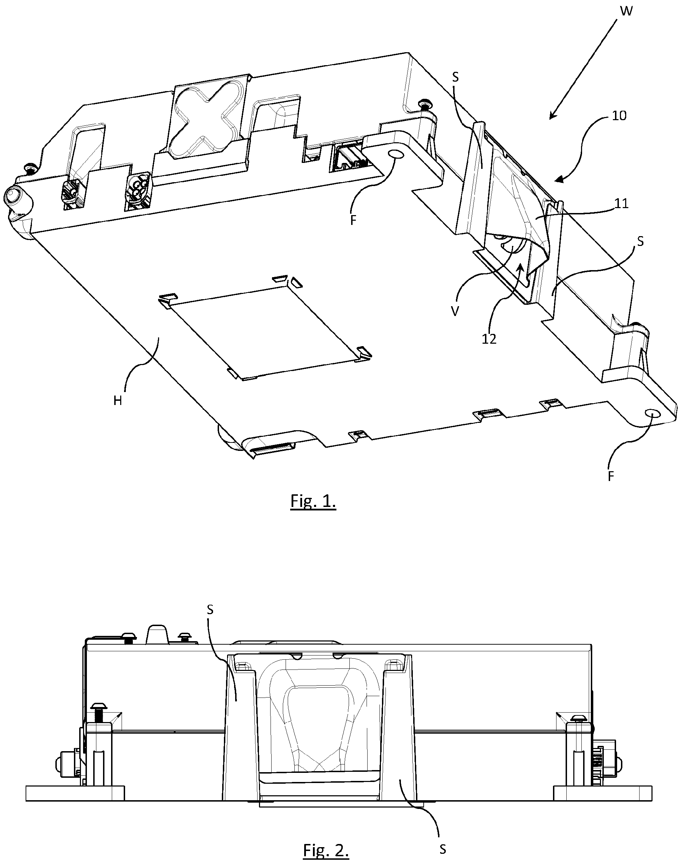

Figure 1 shows a shield 10 according to the invention in place over a vent V to an ECU housing H. Behind the vent V, a cooling fan unit will be located and, further internally, a PCB/processor/component to be cooled. The precise function of the ECU is not critical to the invention, however, a particular application is for an ECU in the automotive field, such as within direct neighbourhood of an HVAC system in a vehicle where condensation is known to develop.

It will be apparent from Figure 1 that shield 10 provides a protective outer wall 11 that serves as a hood/shroud over the openings of vent V such that any fluids dropping or spraying from a direction D above and/or to the side of the housing H will be prevented from entering said housing H. The only access to vent V is via a side/underneath opening/airflow outlet 12 of shield 10, which is effectively a downwards facing (upwardly accessed) opening for diverting airflow from, or into, the vent V transversely/downwardly from naturally lateral direction that would be motivated by the fan within.

If/when housing H is fixed against a mounting surface (not shown), e.g. by fixing brackets F, it will be apparent that only a narrow clearance would be available between that surface and the outlet 12, further minimising the opportunity for fluid to enter vent V.

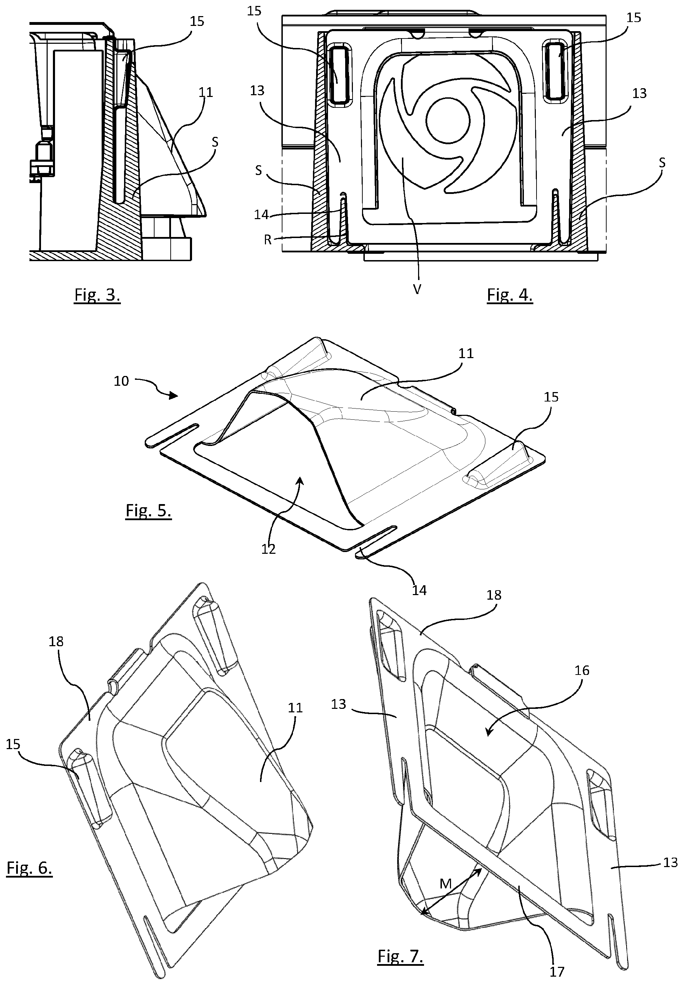

Figures 3 and 4 show side and front elevation section views respectively. Particularly, Figure 3 shows a cross section of a supporting bracket S at either side of the vent V that may slidably receive a side edge 13 of shield 10. As seen in Figures 1 and 2, brackets S provide channels for edges of the shield 13 to slide into.

In the illustrated form, edges 13 slide from above into channels/tracks S and engage, at a distal end, via a bifurcated slot 14 with a locating feature R. Edges 13 also include ridges 15 that serve to engage and lock, via an interference fit, within a wall of channel S. For the avoidance of doubt, Figure 4 shows a view where the vent V is clearly visible through the shield 10 because the outer protective wall 11 is cutaway for convenience of illustration.

Figures 5 to 7 show various perspective views of the shield alone so the structure of the embodiment is clear. For example, Figure 7 best shows a first opening or interfacing side 16 of the shield 10 for interfacing with a fan-cooled unit and/or vent V in a housing H. Interfacing opening 16 is wide and generally corresponds to the outer dimensions of vent V so that airflow therethrough is not impeded. Notably, opening 16 is framed by side edges 13, a lower optional edge 17 and an upper edge 18 which in use, along with side edges 13, is sealed against the housing to prevent ingress of fluid through said edges.

Figure 5 best shows the opening for airflow in use, i.e. mouth or outlet 12 transverse to and communicating with the first open side 16. In use, outlet 12 is for diverting airflow from the fan-cooled unit exiting housing H through vent V. As best seen in Figure 6, the external, outwardly projecting, wall 11 of the shield 10 is contoured in a tapered configuration and, in use, adapted to substantially cover the vent V, for mitigating ingress of fluid not travelling in the direction of open mouth 12; which is to say most/all fluid expected during normal use will not have an opportunity to enter housing H via vent V.

In the illustrated form, wall 11 is contoured to generally taper outwardly from the upper edge 18, against housing H, toward the mouth 12 which is wide so as not to impede airflow. Many contoured or otherwise profiled shapes are possible dependent on the application, however, it is noteworthy that the maximum height of wall 11, at mouth 12, relative to frame edge 17 (see Figure 7 dimension M) is preferably limited by the footprint of housing H. That is to say, referring to Figure 1, the lip of wall 11 at outlet 12 preferably does not extend far beyond, say, the extent of mounting brackets F. In this way, if housing H is required to slot through a tight-fitting arrangement during assembly, shield 10 will not interfere/conflict with other components or structures.

In the illustrated form, shield 10 may be pressed/stamped from sheet metal or similar, from a blank that incorporates slots 14 and a slot opening that is drawn to form outlet 12, along with ridge formations 15.

Various forms of the invention may feature alternative, not-illustrated, fastening elements and mechanisms, such as screws, adhesive, clips, snap-fit arrangements and the like.

The shield may be supplied as a set of multiple shields with a range of dimensions or fastening formations to be attached to a housing specification as needed.

A housing H fitted with a shield 10 according to the invention is ready for testing against ingress of water according to standardised methods for IPx protection, such as where a water jet or shower/splash is aimed at the housing from above where the risk of water occurs (e.g. against the roof of a horizontally positioned housing H as in Figure 1) and the housing or jet is tilted by up to 15 degrees in four directions from vertical during the test. It will be appreciated that a water jet would have to be aimed at the housing at greater than 90 degrees from vertical before water ingress is likely. Such scenarios are highly unlikely in the use situation envisaged for the invention, such as nearby/below an HVAC system where moisture may be present, but the direction of water droplets, etc. are predictable.

The invention enables a method of mitigating ingress of fluid through a vent in a housing of an ECU, e.g. in a vehicle. The method involves the following exemplary steps: determining a fixing orientation of the housing relative to an expected source of fluid, e.g. nearby/under an HVAC unit; providing a protective cover having an outwardly projecting profile wall and an opening; positioning the protective cover over the vent so that the opening faces away from the expected source of fluid such that, in use, the outwardly projecting profile wall deflects the source of fluid. In practice the shield will likely be positioned onto the housing before it is fixed in place for use, i.e. the fixing orientation takes into account where the shield is located and the direction its protective opening is facing.

By way of summary, a shield is described herein for covering a vent or cooling-fan opening in a housing for electronic components. The shield includes an outwardly projecting wall for substantially covering the vent, while leaving a cavity for airflow, and interfaces with the housing at its edges (13) to hold it in place. An opening/outlet in the shield serves to divert airflow to or from the vent or fan-cooled opening while ingress of fluid is mitigated by the outwardly projectable wall, i.e. when aimed from a direction above the housing.

## Claims

1. A shield (10) for a vent (V) or cooling-fan opening in a housing (H) for electronic components, the shield comprising:
an outwardly projectable contoured wall (11), of pressed sheet metal, configured for substantially covering the vent (V) or cooling-fan opening and, at edges (13) of the contoured wall (11), interfacing with the housing (H); and
an opening (12) for communicating with the vent or cooling-fan opening to, in use, divert airflow thereto or therefrom while ingress of fluid is mitigated by the contoured wall (11);
wherein the contoured wall (11) is profiled to taper from a narrow end, opposite to the opening, and widen toward the opening;
wherein the edges (13) of the contoured wall are configured to contact with the housing (H) about the vent (V) on at least two sides for sealing therewith;
wherein at least one of the edges (13) comprises an interfacing feature (14, 15) for removably coupling to the housing or vent; and
wherein the interfacing feature (14, 15) is configured to cooperate with a channel provided in the housing.

2. The shield according to claim 1, wherein the interfacing feature (14, 15) includes surface features pressed in the sheet metal selected from at least one of: holes, profiles, ridges that serve to engage and lock, and clips.

3. An ECU housing (H) comprising and configured to mount the shield (10) according to any preceding claim, over a vent (V) for a fan unit thereof;
further comprising channels (S), about the vent on at least two sides, for receiving the edges (13) of the contoured wall (11) of the shield.

4. The ECU housing (H) of claim 3, wherein an outwardly projecting dimension (M) of the contoured wall (11) is adapted to be within a footprint of the ECU housing (H).

5. The ECU housing of claim 3 or 4, wherein a set of shields (10) is provided, with a range of dimensions, to be selected for attachment to the channels (S).

6. A method of mitigating ingress of fluid (W) through a vent (V) in a housing of an ECU (H), comprising:
determining a fixing orientation of the housing relative to an expected source of fluid (W);
providing a shield (10) according to claim 1 or 2;
sliding the shield (10) into channels (S) formed in the ECU about the vent (V) so that the opening (12) faces away from the expected source of fluid (W) and, in use, the outwardly projecting contoured wall (11) deflects the source of fluid (W) from the vent (V).

7. The method of claim 6, wherein the housing (H) is fixed into a vehicle.

## Patentansprüche

1. Eine Abdeckung (10) für eine Lüftungsöffnung (V) oder eine Öffnung für einen Kühllüfter in einem Gehäuse (H) für elektronische Komponenten, die Abdeckung umfassend:
eine nach außen ausklappbare, konturierte Wand (11) aus gepresstem Metallblech, die so konfiguriert ist, dass sie die Lüftungsöffnung (V) oder die Öffnung für den Kühllüfter im Wesentlichen abdeckt und an den Rändern (13) der konturierten Wand (11) mit dem Gehäuse (H) in Kontakt steht; und
eine Öffnung (12) zur Verbindung mit der Lüftungsöffnung oder der Öffnung für den Kühllüfter, um im Betrieb den Luftstrom zu dieser hin oder von dieser weg zu leiten, während das Eindringen von Flüssigkeit durch die konturierte Wand (11) vermindert wird;
wobei die konturierte Wand (11) so profiliert ist, dass sie sich von einem schmalen, der Öffnung gegenüberliegenden Ende ausgehend verjüngt und sich zur Öffnung hin verbreitert;
wobei die Ränder (13) der konturierten Wand so konfiguriert sind, dass sie das Gehäuse (H) im Bereich der Lüftungsöffnung (V) an mindestens zwei Seiten zur Abdichtung daran berühren;
wobei mindestens einer der Ränder (13) ein Verbindungselement (14, 15) zum lösbaren Verbinden mit dem Gehäuse oder der Lüftungsöffnung aufweist; und
wobei das Verbindungselement (14, 15) so konfiguriert ist, dass es mit einem im Gehäuse vorgesehenen Kanal zusammenwirkt.

2. Abdeckung nach Anspruch 1, wobei das Verbindungselement (14, 15) in das Metallblech eingepresste Oberflächenstrukturen einschließt, die ausgewählt sind aus mindestens einem aus: Öffnungen, Profilen, Vorsprüngen, die zum Eingreifen und Verriegeln dienen, und Klammern.

3. ECU-Gehäuse (H), umfassend und konfiguriert, um die Abdeckung (10), nach einem der vorstehenden Ansprüche, über einer Lüftungsöffnung (V) für eine zugehörige Lüftereinheit zu montieren;
ferner umfassend Kanäle (S), um die Lüftungsöffnung an mindestens zwei Seiten herum, zum Aufnehmen der Ränder (13) der konturierten Wand (11) der Abdeckung.

4. ECU-Gehäuse (H) nach Anspruch 3, wobei eine nach außen vorstehende Abmessung (M) der konturierten Wand (11) so angepasst ist, dass sie innerhalb einer Grundfläche des ECU-Gehäuses (H) liegt.

5. ECU-Gehäuse nach Anspruch 3 oder 4, wobei ein Satz von Schutzschilden (10) mit unterschiedlichen Abmessungen vorgesehen ist, um zur Befestigung an den Kanälen (S) ausgewählt zu werden.

6. Verfahren zur Verringerung des Eindringens von Flüssigkeit (W) durch eine Lüftungsöffnung (V) in ein Gehäuse einer ECU (H), umfassend:
Bestimmen einer Befestigungsausrichtung des Gehäuses relativ zu einer erwarteten Flüssigkeitsquelle (W);
Bereitstellen einer Abdeckung (10) nach Anspruch 1 oder 2;
Einschieben der Abdeckung (10) in die in der ECU um die Lüftungsöffnung (V) ausgebildeten Kanäle (S), sodass die Öffnung (12) von der erwarteten Flüssigkeitsquelle (W) weg weist und die nach außen vorstehende konturierte Wand (11) im Betrieb die Flüssigkeitsquelle (W) von der Lüftungsöffnung (V) ablenkt.

7. Verfahren nach Anspruch 6, wobei das Gehäuse (H) in einem Fahrzeug angebracht ist.

## Revendications

1. Écran (10) destiné à un évent (V) ou à une ouverture de ventilateur de refroidissement dans un boîtier (H) pour composants électroniques, l'écran comprenant :
une paroi profilée (11), en tôle emboutie, pouvant faire saillie vers l'extérieur, conçue pour recouvrir pratiquement l'évent (V) ou l'ouverture de ventilateur de refroidissement et, au niveau des bords (13) de la paroi profilée (11), faire l'interface avec le boîtier (H) ; et
une ouverture (12) destiné à communiquer avec l'évent ou l'ouverture de ventilateur de refroidissement pour, lors de l'utilisation, dévier le flux d'air vers celle-ci ou à partir de celle-ci pendant que l'entrée de fluide est atténuée par la paroi profilée (11) ;
dans lequel la paroi profilée (11) est profilée pour se rétrécir à partir d'une extrémité étroite, en regard de l'ouverture, et à s'élargir vers l'ouverture ;
dans lequel les bords (13) de la paroi profilée sont conçus pour entrer en contact avec le boîtier (H) autour de l'évent (V) sur au moins deux côtés pour assurer l'étanchéité avec celui-ci ;
dans lequel au moins un des bords (13) comprend un élément d'interface (14, 15) destiné à être accouplé de manière amovible au boîtier ou à l'évent ; et
dans lequel l'élément d'interface (14, 15) est conçue pour coopérer avec un canal ménagé dans le boîtier.

2. Écran selon la revendication 1, dans lequel l'élément d'interface (14, 15) comporte des éléments de surface pressés dans la tôle métallique sélectionnés parmi au moins l'un des éléments suivants : trous, profils, nervures qui servent à venir en prise et à verrouiller et agrafes.

3. Boîtier de l'unité de commande électronique (ECU) comprenant et conçu pour monter l'écran (10) selon une quelconque revendication précédente, sur un évent (V) destiné à une unité de ventilateur de celui-ci ;
comprenant en outre des canaux (S), autour de l'évent sur au moins deux côtés, destinés à recevoir les bords (13) de la paroi profilée (11) de l'écran.

4. Boîtier de l'ECU (H) selon la revendication 3, dans lequel une dimension (M) faisant saillie vers l'extérieur de la paroi profilée (11) est adaptée à se trouver à l'intérieur d'une empreinte du boîtier de l'ECU (H).

5. Boîtier de l'ECU selon la revendication 3 ou 4, dans lequel un ensemble d'écrans (10) est prévu, avec une plage de dimensions, pour être sélectionné pour fixation aux canaux (S).

6. Procédé d'atténuation de l'entrée de fluide (W) à travers un évent (V) dans un boîtier d'une ECU (H), comprenant :
la détermination d'une orientation de fixation du boîtier par rapport à une source attendue de fluide (W) ;
la fourniture d'un écran (10) selon la revendication 1 ou 2 ;
le glissement de l'écran (10) dans des canaux (S) formés dans l'ECU autour de l'évent (V) de sorte que l'ouverture (12) se trouve à l'opposé de la source attendue de fluide (W) et, lors de l'utilisation, la paroi profilée (11) faisant saillie vers l'extérieur dévie la source de fluide (W) de l'évent (V).

7. Procédé selon la revendication 6, dans lequel le boîtier (H) est fixé dans un véhicule.
